# EUROPEAN PATENT APPLICATION

(11) **EP 4 187 611 A1**
(43) Date of publication of application: **31.05.2023**
(21) Application number: 22203652.7
(22) Date of filing: 25.10.2022
(51) Int. Cl.: H01L 29/06, H01L 21/336, H01L 29/775, H01L 29/423, H01L 29/78, B82Y 10/00

(54) **STRAINED SEMICONDUCTOR ON INSULATOR (SSOI) BASED GATE ALL AROUND (GAA) TRANSISTOR STRUCTURES**

(30) Priority: 29.11.2021 US 202117536725
(71) Applicant: INTEL Corporation, Santa Clara, CA 95054 (US)
(72) Inventor: MURTHY, Anand S., Portland, 97229 (US); MAJHI, Prashant, San Jose, 95121 (US); GLASS, Glenn A., Portland, 97229 (US)
(74) Representative: 2SPL Patentanwälte PartG mbB

(57) **Abstract**

A gate-all-around transistor device includes a substrate, and a layer over the substrate, where the layer includes an insulator material. The device also includes a source region and a drain region, and a body that includes a semiconductor material over the layer and that laterally extends between the source and drain regions. In an example, the semiconductor material of the body is under biaxial tensile strain induced by an underlying strained semiconductor on insulator (SSOI) structure, in addition to any additional strain induced by the source and drain regions (if any). A gate structure is at least in part wrapped around the body, where the gate structure includes (i) a gate electrode and (ii) a gate dielectric between the body and the gate electrode. The body can be, for instance, a nanoribbon, nanosheet, or nanowire.

## Description

### BACKGROUND

Semiconductor devices are electronic components that exploit the electronic properties of semiconductor materials, such as silicon (Si), germanium (Ge), gallium arsenide (GaAs), and indium phosphide (InP). A field-effect transistor (FET) is a semiconductor device that includes three terminals: a gate, a source, and a drain. A FET uses an electric field applied by the gate to control the electrical conductivity of a channel through which charge carriers (e.g., electrons or holes) flow between the source and drain. In instances where the charge carriers are electrons, the FET is referred to as an n-channel device; and in instances where the charge carriers are holes, the FET is referred to as a p-channel device. Some FETs have a fourth terminal called the body or substrate, which can be used to bias the transistor. In addition, metal-oxide-semiconductor FETs (MOSFETs) include a gate dielectric between the gate and the channel. MOSFETs may also be known as metal-insulator-semiconductor FETs (MISFETSs) or insulated-gate FETs (IGFETs). Complementary MOS (CMOS) structures use a combination of p-channel MOSFET (PMOS) and n-channel MOSFET (NMOS) devices to implement logic gates and other digital circuits.

A FinFET is a MOSFET transistor built around a thin strip of semiconductor material (generally referred to as a fin). The conductive channel of the FinFET device resides on the outer portions of the fin adjacent to the gate dielectric. Specifically, current runs along/within both sidewalls of the fin (sides perpendicular to the substrate surface) as well as along the top of the fin (side parallel to the substrate surface). Because the conductive channel of such configurations includes three different planer regions of the fin (e.g., top and two sides), such a FinFET design is sometimes referred to as a tri-gate transistor. A nanowire transistor (sometimes referred to as a gate-all-around (GAA)) is configured similarly to a fin-based transistor, but instead of a finned channel region, one or more nanowires extend between the source and the drain regions. In nanowire transistors the gate material wraps around each nanowire (hence, gate-all-around).

### BRIEF DESCRIPTION OF THE DRAWINGS

Figs. 1A-1C illustrate a perspective and cross-sectional views of an example GAA semiconductor structure having a strained channel and formed on a strained semiconductor on insulator (SSOI) base, in accordance with an embodiment of the present disclosure.
Fig. 2A illustrates a flowchart depicting a method of forming the example GAA semiconductor structure of Figs. 1A-1C, in accordance with an embodiment of the present disclosure.
Fig. 2B illustrates a flowchart depicting an example method of forming the SSOI base used in the semiconductor structure of Figs. 1A-1C, in accordance with an embodiment of the present disclosure.
Figs. 3A-3G collectively illustrate cross-sectional views of an example semiconductor structure in various stages of processing, in accordance with an embodiment of the present disclosure.
Figs. 4A-4D collectively illustrate cross-sectional views of an example SSOI base in various stages of processing, in accordance with an embodiment of the present disclosure.
Fig. 5 illustrates a computing system implemented with integrated circuit structures and/or transistor devices formed using the techniques disclosed herein, in accordance with an embodiment of the present disclosure.

These and other features of the present embodiments will be understood better by reading the following detailed description, taken together with the figures herein described. In the drawings, each identical or nearly identical component that is illustrated in various figures may be represented by a like numeral. For purposes of clarity, not every component may be labeled in every drawing. Furthermore, as will be appreciated, the figures are not necessarily drawn to scale or intended to limit the described embodiments to the specific configurations shown. For instance, while some figures generally indicate straight lines, right angles, and smooth surfaces, an actual implementation of the disclosed techniques may have less than perfect straight lines and right angles (e.g., curved or tapered sidewalls and round corners), and some features may have surface topography or otherwise be non-smooth, given real-world limitations of fabrication processes. Further still, some of the features in the drawings may include a patterned and/or shaded fill, which is merely provided to assist in visually identifying the different features. In short, the figures are provided merely to show example structures.

### DETAILED DESCRIPTION

Integrated circuit structures including transistors having one or more strained semiconductor bodies (e.g., nanoribbons or nanosheets) are provided herein. In an example, a strained semiconductor on insulator (SSOI) base (such as a strained silicon on insulator) is formed, and a GAA transistor is formed over the SSOI base. In one such example, the strained silicon layer of the SSOI may form a bottom-most nanoribbon of the GAA transistor. In any case, the strain (e.g., biaxial tensile strain) from the strained silicon (Si) layer of the SSOI is propagated to the upper nanoribbons of the GAA transistor, e.g., because of lattice matching of the upper nanoribbons with the strained silicon layer of the SSOI. The source and drain regions of the GAA transistor are formed, which may maintain the strain and/or cause additional strain in the nanoribbons. Thus, strain of the nanoribbons is biaxial in that it is induced in the x and y axes directions by the SSOI structure. In an example, the biaxial strain is maintained by and/or increased by the source and drain regions. Having strained nanoribbons improves carrier mobility in the channel region, thereby improving performance of the GAA transistor.

In one example embodiment, a semiconductor structure comprises a substrate, a layer comprising an insulating material (e.g., oxide) over the substrate, and a source region and a drain region. A body comprising a semiconductor material is over the layer and between the source and drain regions, where the semiconductor material of the body is under strain in one or more axes, e.g., biaxial strain in the x-axis and y-axis direction. A gate structure is at least in part wrapped around the body, where the gate structure includes (i) a gate electrode and (ii) a gate dielectric between the body and the gate electrode. In some cases, the body is a nanoribbon or nanosheet, and the gate structure wraps around the nanoribbon or nanosheet.

In another example embodiment, an integrated circuit structure comprises a first body and a second body each including a semiconductor material that is under strain in one or more axes (e.g., biaxial strain in the x-axis and y-axis direction), and a source region and a drain region. The first body and the second body are between the source and drain regions. In an example, a gate structure only partially wraps around the first body and fully wraps around the second body. In an example, the gate structure includes (i) a gate electrode and (ii) gate dielectric separating the gate electrode from the first and second bodies.

In yet another example embodiment, a method of forming a semiconductor device comprises forming a SSOI structure comprising (i) a substrate, (ii) a first layer of insulating material over the substrate, and (iii) a second layer comprising strained silicon over the first layer. The method also includes forming alternating layers of semiconductor channel material and sacrificial material, wherein the strain in the second layer is propagated to, or otherwise induced in, the layers of channel material. The inducement of strain is due to lattice matching between the strained second layer and the alternating layers that are sequentially formed thereon. The second layer and the alternating layers of channel material and sacrificial material are etched, to define a fin comprising corresponding sections of the second layer and the alternating layers of channel material and sacrificial material. The method also comprises etching the section of the sacrificial material from the fin, to release the alternating layers of channel material, wherein the sections of the second layer and the alternating layers of channel material form a plurality of nanoribbons or nanosheets comprising strained silicon. Note that, in some cases, the section of the second layer may also provide a partially released nanoribbon or nanosheet, where the underside of that partially released body is in contact with the first layer.

Methodologies and structures of the present disclosure can provide improved nanoribbons (or nanosheets or nanowires, as the case may be) that have tensile strain induced from an underlying strained silicon layer of an SSOI structure, as well as from laterally adjacent source and drain regions.

### General Overview

Field effect transistors (FETs) have been scaled to smaller and smaller sizes to achieve faster circuit operation. Such scaling has resulted in the development of gate-all-around (GAA) transistors, examples of which include nanowire or nanoribbon transistors, and forksheet transistors. For example, the GAA channel region can have nanoribbons extending between the source and drain regions, such as a vertical stack of nanoribbons that extend horizontally between the source and drain regions. Generally, strain in a nanoribbon or nanowire (or nanosheet) improves carrier mobility in that nanoribbon or nanowire. Introducing strain in such semiconductor bodies, particularly nanoribbons and nanosheets given their pancake-like shape, remains a challenge in process flow of GAA transistors.

Thus, and in accordance with various embodiments of the present disclosure, techniques are disclosed for forming transistor devices having strained channel regions. The techniques can be used with any number of transistor technologies, and are particularly useful for GAA transistors. The strained channel regions improve carrier mobility, resulting in better performance of the transistor.

In an example, the GAA transistor having strained nanoribbons is formed from a multilayer stack formed on a strained semiconductor on insulator (SSOI) base. In some cases, for instance, the SSOI base includes a buried oxide layer (BOX) sandwiched between a substrate (e.g., comprising silicon) and a strained semiconductor (such as strained silicon (Si)) layer. In the final GAA transistor, the strained silicon layer is to form a bottom-most nanoribbon of the GAA transistor.

After forming the SSOI base, alternating layers of silicon germanium (SiGe) sacrificial material and semiconductor channel material (e.g., Si) are formed (e.g., epitaxially deposited) over the SSOI structure, according to some embodiments. The alternating layers of SiGe sacrificial material and Si channel material are lattice matched with the strained Si layer of the SSOI structure. Due to this lattice matching, the layers of SiGe sacrificial material include relaxed (or at least partially strained) SiGe, and the layers of channel material include strained Si. That is, the strain from the SSOI structure is propagated to the layers of Si channel material.

Subsequently, the strained Si layer of the SSOI structure and the alternating layers of SiGe sacrificial material and strained Si channel material are etched, to define a multilayer fin. During a gate forming process, the SiGe sacrificial material is selectively removed (e.g., etched), to release the Si nanoribbons, where a bottom-most nanoribbon may comprise a section of the strained Si layer of the SSOI structure, and upper nanoribbons comprise corresponding sections of the strained Si channel material of the alternating layers (note that the bottom-most nanoribbon is not fully released, as it may be directly to the insulator layer of the SSOI base). Thus, all the nanoribbons of the GAA transistor are under biaxial tensile strain induced by the underlying SSOI base. Note that the bottom-most nanoribbon is part of the original SSOI base. Furthermore, the epitaxial source and drain regions of the GAA transistor may maintain or further induce strain in the nanoribbons, thus providing biaxial strain to the nanoribbons.

In an example, because the bottom-most nanoribbon is part of the original SSOI base, the bottom-most nanoribbon is formed directly on the insulator or BOX layer of the SSOI base. Accordingly, if the underlying portion of the BOX layer is not etched away from that bottom-most nanoribbon, then that bottom-most nanoribbon is not fully released and the gate stack (e.g., gate dielectric, gate electrode, and gate spacers) only partially wraps around the bottom-most nanoribbon. In contrast, the gate stack can fully wrap around the upper nanoribbons of the GAA transistor. In other examples, the bottom-most nanoribbon of the SSOI base can be fully released if so desired by, for instance, etching away at least part of the underlying BOX layer. This underside release of the bottom-most nanoribbon of the SSOI base can be done, for example, during gate processing that includes removal of dummy gate material from the gate trench, in a remove metal gate (RMG) process. In such a case, the insulator material of the BOX layer can be selected such that it can be selectively etched with respect to other materials exposed during gate processing.

As discussed, strain of the nanoribbons is induced from two sources: biaxial strain induced by the SSOI base, and the strain that is maintained by the source and drain regions. Having such biaxial strained nanoribbons improve carrier mobility in the channel region, thereby improving performance of the GAA transistor.

As will be further appreciated in light of this disclosure, reference to nanoribbons is also intended to include other gate-all-around channel regions, such as nanowires, nanosheets, and other such semiconductor bodies around which a gate structure can wrap. To this end, the use of a specific channel region configuration (e.g., nanoribbon) is not intended to limit the present description to that specific channel configuration. Rather, the techniques provided herein can benefit any number of channel configurations that include semiconductor bodies in which it is difficult to impart lateral strain, whether those bodies be nanowires, nanoribbons, nanosheets or some other body (such as the semiconductor bodies of a forksheet device).

The use of "group IV semiconductor material" (or "group IV material" or generally, "IV") herein includes at least one group IV element (e.g., silicon, germanium, carbon, tin), such as silicon (Si), germanium (Ge), silicon-germanium (SiGe), and so forth. The use of "group III-V semiconductor material" (or "group III-V material" or generally, "III-V") herein includes at least one group III element (e.g., aluminum, gallium, indium) and at least one group V element (e.g., nitrogen, phosphorus, arsenic, antimony, bismuth), such as gallium arsenide (GaAs), indium gallium arsenide (InGaAs), indium aluminum arsenide (InAlAs), gallium phosphide (GaP), gallium antimonide (GaSb), indium phosphide (InP), gallium nitride (GaN), and so forth. Note that group III may also be known as the boron group or IUPAC group 13, group IV may also be known as the carbon group or IUPAC group 14, and group V may also be known as the nitrogen family or IUPAC group 15, for example.

Materials that are "compositionally different" or "compositionally distinct" as used herein refers to two materials that have different chemical compositions. This compositional difference may be, for instance, by virtue of an element that is in one material but not the other (e.g., SiGe is compositionally different than silicon), or by way of one material having all the same elements as a second material but at least one of those elements is intentionally provided at a different concentration in one material relative to the other material (e.g., SiGe having 70 atomic percent germanium is compositionally different than from SiGe having 25 atomic percent germanium). In addition to such chemical composition diversity, the materials may also have distinct dopants (e.g., gallium and magnesium) or the same dopants but at differing concentrations. In still other embodiments, compositionally distinct materials may further refer to two materials that have different crystallographic orientations. For instance, (110) silicon is compositionally distinct or different from (100) silicon. Creating a stack of different orientations could be accomplished, for instance, with blanket wafer layer transfer. If two materials are elementally different, then one of the material has an element that is not in the other material.

In some embodiments, a plurality of channel layers of compositionally different channel materials or geometries may be formed on different areas of the substrate, such as for CMOS applications, for example. For instance, a first channel material layer may be formed on a first area of a silicon base to be used for one or more p-channel transistor devices (e.g., one or more PMOS devices) and a second channel material layer may be formed on a second area of the silicon base to be used for one or more n-channel transistor devices (e.g., one or more NMOS devices). As previously described, by selecting the substrate to have the desired material characteristics (e.g., the desired semiconductor material, the desired dopant concentration, and desired dopant type) the substrate can be used to grow multiple different channel layers.

Note that the use of "source/drain" herein is simply intended to refer to a source region or a drain region or both a source region and a drain region. To this end, the forward slash ("/") as used herein means "and/or" unless otherwise specified, and is not intended to implicate any particular structural limitation or arrangement with respect to source and drain regions, or any other materials or features that are listed herein in conjunction with a forward slash.

Use of the techniques and structures provided herein may be detectable using tools such as electron microscopy including scanning/transmission electron microscopy (SEM/TEM), scanning transmission electron microscopy (STEM), nano-beam electron diffraction (NBD or NBED), and reflection electron microscopy (REM); composition mapping; x-ray crystallography or diffraction (XRD); energy-dispersive x-ray spectroscopy (EDX); secondary ion mass spectrometry (SIMS); time-of-flight SIMS (ToF-SIMS); atom probe imaging or tomography; local electrode atom probe (LEAP) techniques; 3D tomography; or high resolution physical or chemical analysis, to name a few suitable example analytical tools. In particular, in some embodiments, such tools may indicate a transistor with nanoribbons, nanowires, or nanosheets, or other semiconductor body, as the case may be) having tensile strain induced from an underlying SSOI structure. Furthermore, such tools may also be used to detect a bottom-most nanoribbon directly on a buried insulator layer of a SSOI structure. Numerous configurations and variations will be apparent in light of this disclosure.

### Architecture and Methodology

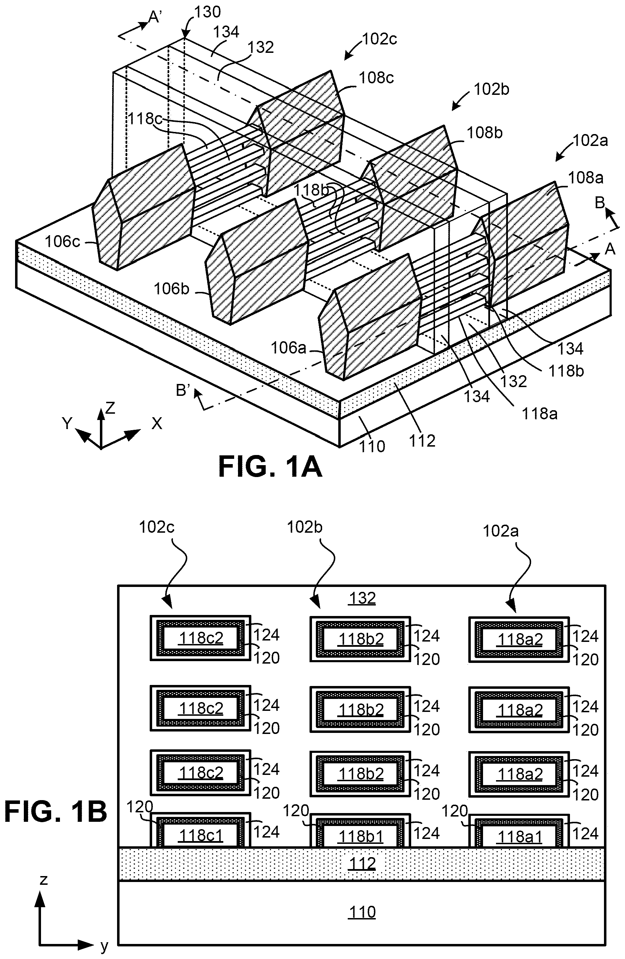

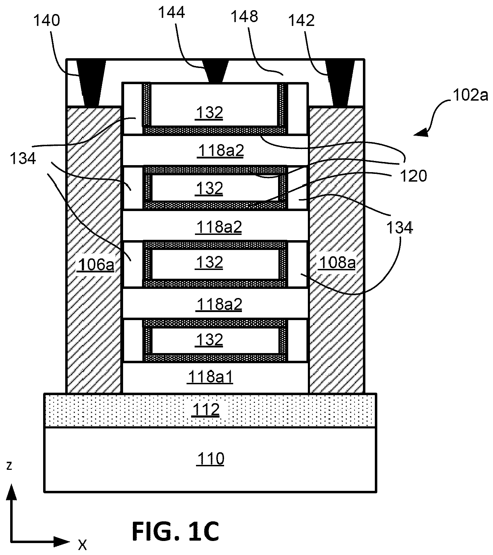

Fig. 1A illustrates a perspective view of an example GAA semiconductor structure 100 (also referred to herein as "structure 100"), Fig. 1B illustrates a cross-sectional view of the GAA semiconductor structure 100, and Fig. 1C illustrates another cross-sectional view of the GAA semiconductor structure 100, where the GAA semiconductor structure 100 comprises GAA devices 102a, 102b, 102c having strained channel and formed on a strained semiconductor on insulator (SSOI) base, in accordance with an embodiment of the present disclosure. In an example, the strained semiconductor on insulator or SSOI base comprises a strained silicon on insulator base.

The cross-sectional view of Fig. 1B is along line A-A' of Fig. 1A. That is, the cross-sectional view of Fig. 1B is along a gate electrode 132 of the structure 100, and this view is also referred to as "gate-cut" view of the structure 100. The cross-sectional view of Fig. 1C is along line B-B' of Fig. 1A. Thus, in the cross-sectional view of Fig. 1C, only the right-most GAA device 102a is visible.

Also, the cross-sectional view of Fig. 1C is along the length of nanoribbons 118a of the device 102a, and entire length of nanoribbons 118a of the device 102a are visible in Fig. 1C. In contrast, the cross-sectional view of Fig. 1B is along a cross-section of the nanoribbons of the three devices 102a, 102b, 102c, and a cross-section of all nanoribbons 118 of all the devices 102a, 102b, 102c are visible in Fig. 1B.

Figs. 1A, 1B illustrate three GAA devices (also referred to herein simply as devices) 102a, 102b, 102c, although the structure 100 can include any other appropriate number of such devices, such as one, two, four, or higher. In one embodiment, the devices 102a, 102b, 102c are nanoribbon transistor devices, although the devices can be any other type of GAA devices. As will be further appreciated in light of this disclosure, reference to nanoribbons is also intended to include other channel regions, such as nanowires, nanosheets, forksheets, and other such semiconductor bodies around which a gate structure can at least partially wrap. To this end, the use of a specific channel region configuration (e.g., nanoribbon) is not intended to limit the present description to that specific channel configuration.

In an example, at least one of the devices 102a, 102b, 102c is complimentary to other ones of the devices 102a, 102b, 102c. Merely as an example, the devices 102a, 102c can be PMOS devices and the device 102b can be an NMOS device. In another example, the devices 102a, 102c can be NMOS devices and the device 102b can be a PMOS device. Any other combination may also be possible. In one embodiment, at least two of the devices 102a, 102b, 102c are configured in a Complementary metal-oxide-semiconductor (CMOS) architecture.

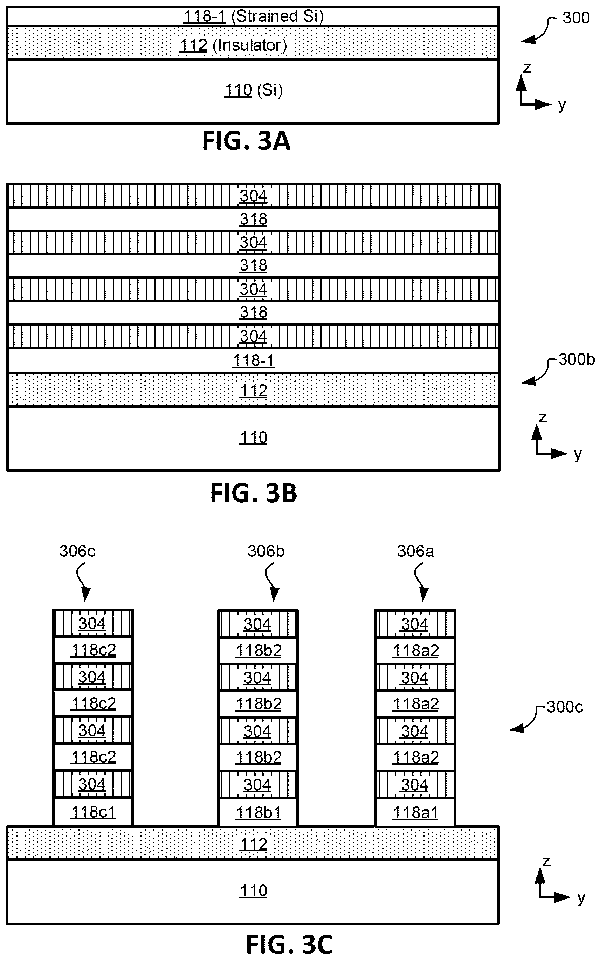

As can be seen, the structure 100 is formed on a base comprising substrate 110 and layer 112. The base in some embodiments may be a strained semiconductor on insulator (SSOI) structure (e.g., where the "semiconductor" of the SSOI is silicon in an example), where the layer 112 comprising insulator/dielectric material (e.g., an oxide material, such as silicon dioxide) is sandwiched between two Si layers (e.g., in a buried oxide (BOX) structure). The layer 112 is also referred to herein as insulator layer 112. Note that in a SSOI structure, the middle insulator layer 112 is sandwiched between two silicon layers, where the bottom silicon layer is the substrate 110 and the top silicon layer comprises the bottom-most nanoribbons 118a1, 118b1, 118c1 of the devices 102a, 102b, 102c, as will be discussed in further detail herein later (e.g., see Fig. 3A for an example SSOI structure 300 used to form the structure 100).

In some embodiments, the substrate 110 may be doped with any suitable n-type and/or p-type dopant at a dopant concentration in the range of 1E16 to 1E22 atoms per cubic cm, for example. For instance, a silicon base can be p-type doped using a suitable acceptor (e.g., boron) or n-type doped using a suitable donor (e.g., phosphorous, arsenic) with a doping concentration of at least 1E16 atoms per cubic cm. However, in some embodiments, the base may be undoped/intrinsic or relatively minimally doped (such as including a dopant concentration of less than 1E16 atoms per cubic cm), for example. In some embodiments, the substrate 110 is a silicon substrate consisting essentially of Si. In other embodiments, the substrate 110 may primarily include Si but may also include other material (e.g., a dopant at a given concentration). Also, note that the base material may include relatively high quality or device-quality monocrystalline Si or other material that provides a suitable template or seeding surface from which other monocrystalline semiconductor material features and layers can be formed. In some embodiments, the substrate 110 may have a crystalline orientation described by a Miller index of (100), (110), or (111), or its equivalents, as will be apparent in light of this disclosure. For example, the substrate 110 may have a crystalline orientation described by a Miller index of (100). Although the substrate 110 in this example embodiment is shown for ease of illustration as having a thickness (dimension in the Z-axis direction) somewhat similar to that of other layers in the figures, the substrate 110 may be relatively much thicker than the other layers, such as having a thickness in the range of 1 to 950 microns (or in the sub-range of 20 to 800 microns), for example, or any other suitable thickness or range of thicknesses as will be apparent in light of this disclosure. In some embodiments, the substrate 110 may include a multilayer structure including two or more distinct layers that may or may not be compositionally different. In some embodiments, the structures described herein may be included in a system-on-chip (SoC) application, as will be apparent in light of this disclosure.

In one embodiment, individual devices 102 (e.g., devices 102a, 102b, 102c) comprise a plurality of nanoribbons 118 (or nanowires, or nanosheets, as the case may be). As seen in Figs. 1B and 1C, the bottom-most nanoribbon in each device 102 is labelled different from other nanoribbons of the device. Any nanoribbon(s) above the bottom-most nanoribbon is also referred to as upper nanoribbon(s) of the device. For example, device 102a comprises a vertical stack of four nanoribbons - a bottom-most nanoribbon 118a1 and three upper nanoribbons 118a2, 118a2, 118a2. Device 102b comprises a vertical stack of four nanoribbons - a bottom-most nanoribbon 118b1 and three upper nanoribbons 118b1, 118b2, 118b2, 118b2. Device 102c comprises a vertical stack of four nanoribbons - a bottom-most nanoribbon 118c1 and three upper nanoribbons 118c1, 118c2, 118c2, 118c2. The number of nanoribbons 118 in each device 102 (i.e., four nanoribbons per device) is merely an example, and an individual device 102 can comprises a different number of nanoribbons, such as one, two, three, five or higher number of nanoribbons. In an example, each device 102 comprises the bottom-most nanoribbon and one or more upper nanoribbons. In one embodiment, a p-channel device 102 has the corresponding nanoribbons 118 doped with n-type dopants (e.g., phosphorous or arsenic), and an n-channel device 102 has the corresponding nanoribbons 118 doped with p-type dopants (e.g., boron).

Although in Figs. 1A-1B the nanoribbons 118 extend horizontally and are stacked vertically, the present disclosure contemplates nanoribbons in a variety of configurations that include planar nanoribbon transistors, nanoribbons that extend vertically and are stacked horizontally, and other arrangements, as will be appreciated.

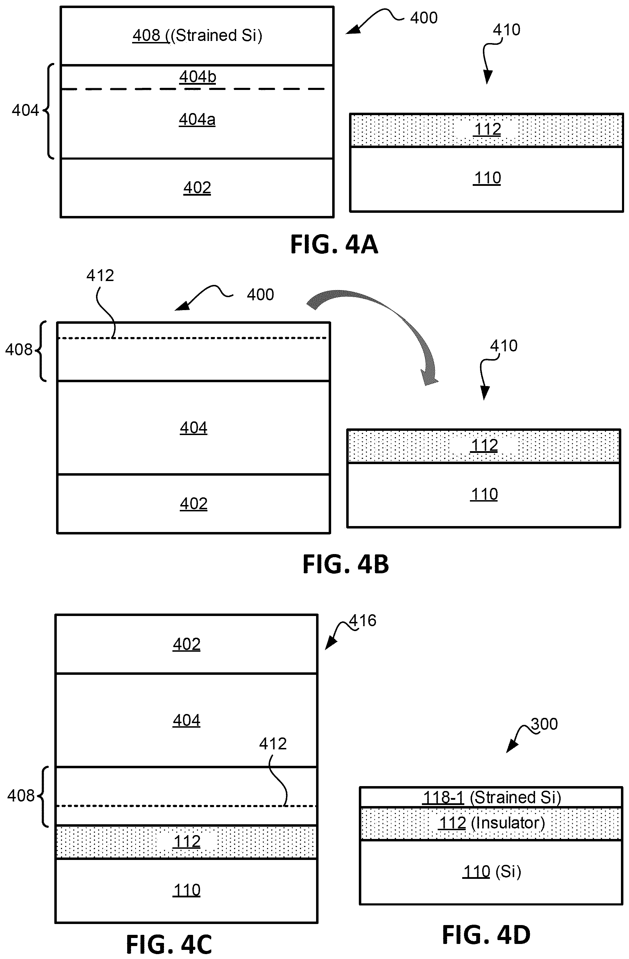

As will be discussed in further detail herein, during formation of the structure 100, the bottom-most nanoribbons 118a1, 118b1, 118c2 are initially a part of a strained silicon layer 118-1 (see Fig. 3A), where the strained silicon layer 118-1 is over the insulator layer 112 (e.g., a buried oxide or BOX layer) and the substrate 110. Thus, the strained silicon layer 118-1, the insulator layer 112, and the substrate 110 form a strained semiconductor on insulator (SSOI) structure, formation of which has been discussed in further detail with respect to Figs. 4A-4D. In an example, the strained semiconductor of the SSOI structure is the strained silicon layer 118-1.

The silicon layer 118-1 is under strain (e.g., biaxial tensile strain), e.g., because of reasons discussed later with respect to Figs. 4A-4D. During formation of the structure 100, alternate layers of Si and sacrificial SiGe layers are epitaxially formed on the strained silicon layer 118-1, where the alternate layers of Si and sacrificial SiGe layers are lattice matched with the strained silicon layer 118-1, as discussed herein later with respect to Fig. 3B. Accordingly, the alternate layers of Si are also under biaxial tensile strain. Note that the alternate layers of strained Si will eventually form the upper nanoribbons of the devices 102a, 102b, 102c. The alternate layers of Si and sacrificial SiGe layers patterned, to form three fins corresponding to the three devices 102a, 102b, 102c, as discussed herein later with respect to Fig. 3C. Before performing the Replacement Metal Gate (RMG) process, the sacrificial SiGe layers are etched, such that the released alternate layers of Si form the upper nanoribbons 182a, 182b, 182c of the devices 102a, 102b, 102c. Note that the tensile strain of the nanoribbons are maintained. Furthermore, the source and drain regions are formed in the devices, which also contributes to the strain of the nanoribbons. Thus, each of the nanoribbons 118a1, 118a2, 118b1, 118b2, 118c1, 118c2 of the devices of the structure 100 are under biaxial tensile strain in horizontal x and y axes directions. This improves carrier mobility within the nanoribbon channel regions of the devices 102a, 102b, 102c of the structure 100, thereby improving performance of the devices.

As illustrated in Figs. 1A and 1C, for each device 102, the nanoribbon channel region extends between and connects corresponding source region 106 and drain region 108, where the channel region includes the one or more nanoribbons 118 that extend horizontally and are arranged in a vertical stack. For example, as illustrated in Fig. 1C, device 102a comprises source region 106a and drain region 108a, with the nanoribbons 118a extending horizontally and arranged in a vertical stack between the source region 106a and drain region 108a. Similarly, although not illustrated in Fig. 1C (but illustrated in Fig. 1A), device 102b comprises source region 106b and drain region 108b, with the nanoribbons 118b extending horizontally and arranged in a vertical stack between the source region 106b and drain region 108b. Similarly, device 102c comprises source region 106c and drain region 108c, with the nanoribbons 118c extending horizontally and arranged in a vertical stack between the source region 106c and drain region 108c. Note that the source regions 106 and the drain regions 108 are visible in the perspective view of Fig. 1A, but are not visible in the cross-sectional gate-cut view of Fig. 1B.

According to some embodiments, the source and drain regions 106, 108 are epitaxial regions that are provided using an etch-and-replace process. In other embodiments one or both of the source and drain regions could be, for example, implantation-doped native portions of the semiconductor fins or substrate. Any semiconductor materials suitable for source and drain regions can be used (e.g., group IV and group III-V semiconductor materials). The source and drain regions may include multiple layers such as liners and capping layers to improve contact resistance. In any such cases, the composition and doping of the source and drain regions may be the same or different, depending on the polarity of the transistors. Any semiconductor materials suitable for source and drain regions can be used (e.g., group IV and group III-V semiconductor materials).

Although not illustrated in Figs. 1A and 1B for purposes of illustrative simplicity and illustrated in Fig. 1C, in some embodiments, conductive contacts are formed over source and drain regions 106, 108 and gate electrode 132. For example, Fig. 1C illustrates, for the device 102a, conductive source contacts 140 extending through an Interlayer Dielectric Layer (ILD) 148 and contacting the source region 106a, conductive drain contacts 142 extending through the ILD 148 and contacting the drain region 108a, and conductive gate contacts 144 extending through the ILD 148 and contacting the gate electrode 132. The conductive contacts may be any suitably conductive material. In some embodiments, conductive contacts include one or more of the same metal materials as gate electrode, or a different conductive material.

In the example structure of Figs. 1A-1B, each nanoribbon 118 includes a nanoribbon middle region extending between nanoribbon tip regions, although the nanoribbon middle region and the nanoribbon tip regions are not specifically labelled in the figures. In an example, the nanoribbons 118 comprise silicon and are strained, as will be discussed in further detail herein.

A gate structure 130 contacts and surrounds the nanoribbons 118 between the source and drain regions 106, 108. Note that the gate structure of Fig. 1A is illustrated as being transparent in order to show the geometry of the nanoribbons 118. However, the illustration is not limiting and the materials used to form the gate structure are not necessarily transparent.

In one embodiment, the gate structure 130 includes a gate dielectric 120 (not illustrated in Fig. 1A but illustrated in Figs. 1B and 1C) that wraps around each nanoribbon 118, and a gate electrode 132 that wraps around the gate dielectric 120. In an example, the gate electrode 132 may include any sufficiently conductive material, such as a metal, metal alloy, or doped polysilicon. The gate dielectric 120 may include a single material layer or multiple stacked material layers. In some embodiments, gate dielectric 120 includes a first dielectric layer such as silicon oxide, and a second dielectric layer that includes a high-K material such as hafnium oxide. The hafnium oxide may be doped with an element to affect the threshold voltage of the given semiconductor device. According to some embodiments, the doping element used in gate dielectric 120 is lanthanum. The combination of gate dielectric 120 and gate electrode 132 forms a gate structure for each of semiconductor devices 102a, 102b, 102c. In one embodiment, the gate electrode 132 may be interrupted between any adjacent devices 102 by a gate cut structure. In an example, the middle regions of individual nanoribbons are wrapped by the gate dielectric 120 and the gate electrode 132 (see Fig. 1C). In an example, due to conformal deposition of the gate dielectric 120, the gate dielectric 120 may also be present on inner walls of the gate spacers 134, as seen in Fig. 1C.

In one embodiment, one or more work function metals 124 may be included around the nanoribbons 118, as illustrated in Fig. 1B (note that the work function metals 124 are not illustrated in Figs. 1A and 1C, for purposes of illustrative clarity). In some embodiments, a p-channel device 102 may include a work function metal having titanium, and an n-channel device 102 may include a work function metal having tungsten. In some other embodiments, the work function metal may be absent around one or more nanoribbons 118.

As seen in the cross-sectional view of Fig. 1B (and also in Fig. 1C), the bottom-most nanoribbon of individual devices 102a, 102b, 102c is formed directly on the insulator layer 112. Accordingly, the dielectric layer 120 and the work function metal layer 124 are on top and side surfaces, but not on the bottom surface, of the bottom-most nanoribbons 181a1, 181b1, 181c1 of individual devices 102a, 102b, 102c. The bottom surface of the bottom-most nanoribbon of individual devices 102a, 102b, 102c is in direct contact with the insulator layer 112. Thus, the bottom-most nanoribbon of individual devices 102a, 102b, 102c are partially, but not fully, wrapped around by the dielectric layer 120 and the work function metal layer 124. In contrast, the upper nanoribbons 118a2, 118b2, 118c2 of each device 102 are fully wrapped around by the dielectric layer 120 and the work function metal layer 124, as illustrated in Fig. 1B.

The gate structure 130 also includes gate spacers 134 that extend along the sides of the gate electrode 132, to isolate the gate electrode 132 from the source and drain regions 106, 108. The gate spacers 134 surround the tip regions of the nanoribbons 118 (e.g., see Fig. 1C) and are located between the gate electrode 132 and the source and drain regions 106, 108. In one embodiment, gate spacers 134 may include a dielectric material, such as silicon nitride.

As seen in the cross-sectional view of Fig. 1C, the bottom-most nanoribbon of individual devices 102a, 102b, 102c is formed directly on the insulator layer 112. Accordingly, the gate spacers 134 are on top and side surfaces, but not on the bottom surface, of the bottom-most nanoribbons 181a1, 181b1, 181c1 of individual devices 102a, 102b, 102c. Thus, the bottom-most nanoribbon of individual devices 102a, 102b, 102c are partially, but not fully, wrapped around by the gate spacers 134. In contrast, the upper nanoribbons 118a2, 118b2, 118c2 of each device 102 are fully wrapped around by the gate spacers 134.

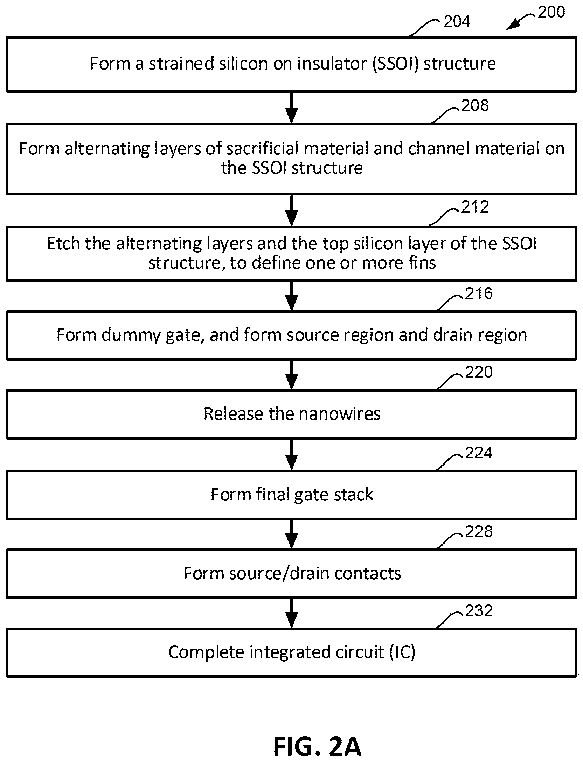

Fig. 2A illustrates a flowchart depicting a method 200 of forming the example nanoribbon semiconductor structure 100 of Figs. 1A-1C, in accordance with an embodiment of the present disclosure. Figs. 3A-3G collectively illustrate cross-sectional views of an example semiconductor structure (e.g., the semiconductor structure 100 of Figs. 1A-1C) in various stages of processing, in accordance with an embodiment of the present disclosure. Figs. 2A and 3A-3G will be discussed in unison.

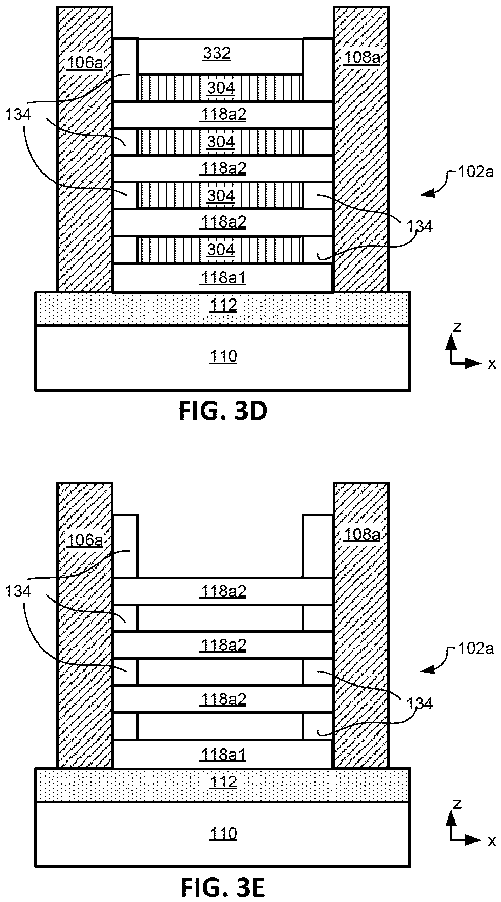

In Figs. 3A-3C, the cross-sectional views are along line A-A' of Fig. 1A (e.g., similar to Fig. 3B). In Figs. 3D-3G, the cross-sectional views are along line B-B' of Fig. 1A (e.g., similar to Fig. 3C). Thus, Figs. 3D-3G illustrates formation of a single device 102a, and devices 102b and 102c may also be formed in at least in part similar manner.

Referring to Fig. 2A, the method 200 includes, at 204, forming a SSOI structure. For example, Fig. 3A illustrates the SSOI structure 300, where a strained Si layer 118-1 is on the insulator layer 112. The insulator layer 112 is sandwiched between the strained Si layer 118-1 and the silicon substrate 110. The insulator layer 112 is a buried oxide layer (BOX) in an example. For example, the insulator layer 112 is an oxide layer, such as SiO2, although another appropriate insulator layer may also be used.

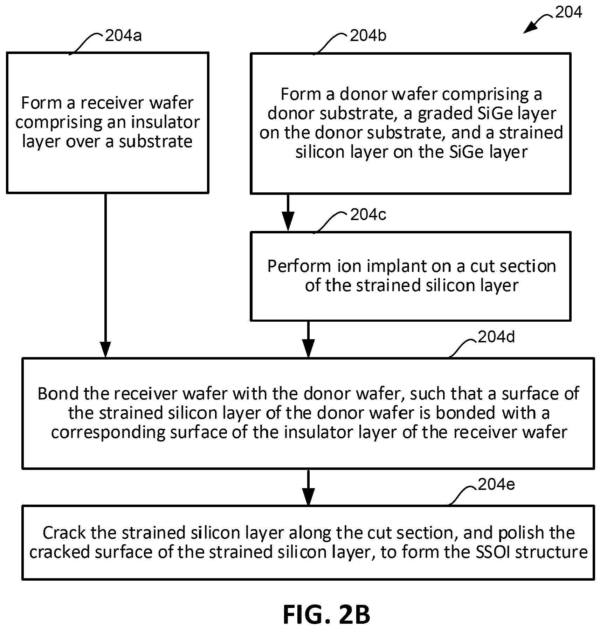

The SSOI structure 300 can be formed using a suitable technique for forming silicon on insulator (SOI), with the top silicon layer being a strained semiconductor (e.g., silicon) layer. Some example SIO (silicon on insulator) formation techniques include SIMOX (separation by implanted oxygen), BESOI (bonded and etch-back SOI), and Smart Cut technique. A suitable SOI process, with the top silicon layer being strained, may be used to form the SSOI structure 300. Fig. 2B illustrates a flowchart depicting an example method 204 of forming the SSOI base used in the semiconductor structure 100 of Figs. 1A-1C, in accordance with an embodiment of the present disclosure. Thus, Fig. 2B illustrates the operations 204 of the method 200 of Fig. 2A in further detail. Figs. 4A-4D collectively illustrate cross-sectional views of an example SSOI base in various stages of processing, as discussed with respect to the method 204 of Fig. 2B, in accordance with an embodiment of the present disclosure. It may be noted that while Figs. 2B and 4A-4D illustrate one example technique to form the SSOI structure 300, another appropriate technique may also be used to form the SSOI structure 300.

Referring to the method 204 of Fig. 2B, at 204a a receiver wafer comprising an insulator layer over a substrate (e.g., a Si substrate) is formed. For example, Fig. 4A illustrates a receiver wafer 310 comprising an insulator layer 112 (e.g., a buried oxide layer) over a Si substrate 110. In an example, a top surface of the Si substrate 110 is oxidized, to form SiO2 insulator layer 112 of the receiver wafer 310.

The method 204 further comprises, at 204b, forming a donor wafer comprising a donor substrate, a graded SiGe layer on the donor substrate, and a strained silicon layer on the SiGe layer. For example, Fig. 4A also illustrates a donor wafer 400 comprising a donor substrate 402, a graded SiGe layer 404 on the donor substrate 402, and a strained silicon layer 408 on the SiGe layer 404. The substrate 402 can be any appropriate substrate, and in an example, the substrate 402 comprises bulk silicon. The SiGe layer 404 is graded from a low concentration of Ge near a surface adjacent to the substrate 402 to a high concentration of Ge near an opposite surface adjacent to the Si layer 408. Thus, in the orientation depicted in Fig. 4A, the Ge concentration increases from bottom to the top within the SiGe layer 404. Two example sub-layers 404a and 404b of the SiGe layer 404 are illustrated in Fig. 4A, where Ge concentration in the sub-layer 404b is higher than Ge concentration in the sub-layer 404a. The bottom section of the layer 404 (e.g., bottom section of the sublayer 404a) is lattice matched to the silicon substrate 402, and comprises strained SiGe. The top section of the layer 404 (e.g., the sub-layer 404b), on the other hand, comprises relaxed SiGe. Thus, the strain on the SiGe of the layer 404 decreases from bottom to the top, and the sub-layer 404b comprises fully relaxed SiGe. The SiGe layer 404 can be formed over the substrate 402 using any suitable techniques, such as chemical vapor deposition (CVD), physical vapor deposition (PVD), atomic layer deposition (ALD), vapor-phase epitaxy (VPE), molecular beam epitaxy (MBE), or liquid-phase epitaxy (LPE), for example.

Subsequently, the Si layer 408 is formed over the sub-layer 404b using any suitable techniques, such as chemical vapor deposition (CVD), physical vapor deposition (PVD), atomic layer deposition (ALD), vapor-phase epitaxy (VPE), molecular beam epitaxy (MBE), or liquid-phase epitaxy (LPE), for example. The Si of the layer 408 lattice matches with the relaxed SiGe of the sub-layer 404b, resulting in strained Si of the layer 408. For example, the layer 408 comprises Si under tensile strain, e.g., due to the lattice matching with the relaxed SiGe of the sub-layer 404b.

Referring again to Fig. 2B, the method 204 then proceeds from 204b to 204c, where ion implant to implant hydrogen ions on a cut section of the strained silicon layer is performed. For example, Fig. 4B illustrates a cut section 412 illustrated using a dotted line. A depth at which the cut section 412 is formed within the Si layer 408 can be controlled by controlling parameters of the ion implantation process.

Referring again to Fig. 2B, the operations at 204a are performed in parallel with the operations at 204b and 204c. Subsequent to 204a and 204c, the method 204 proceeds to 204d, where the receiver wafer is bonded with the donor wafer. For example, Fig. 4B symbolically illustrates the boding process using an arrow, and Fig. 4C illustrates the bonded structure 416. For example, a top surface of the strained silicon layer 408 of the donor wafer 400 is bonded with a corresponding top surface of the insulator layer 112 of the receiver wafer 410, as illustrated in Fig. 4B and 4C. For example, in Figs. 4B and 4C, the donor wafer 400 is flipped upside-down and bonded with the receiver wafer 410.

Referring again to Fig. 2B, the method 204 then proceeds from 204d to 204e, where the strained silicon layer is cracked along the cut section, and the cracked surface of the strained silicon layer is polished. For example, the structure 416 of Fig. 4C is annealed, which results in hydrogen bubble formation (e.g., due to the previously implanted hydrogen ions) and subsequent cracking along the cut section 412 within the strained silicon layer 408. Fig. 4D illustrates the SSOI, after the cracking and polishing. The cracked top surface of the strained silicon layer 408 can be polished using any suitable polishing or planarization technique, such as Chemical-mechanical polishing (CMP). After the cracking and polishing, in the structure 300 of Fig. 4D, a bottom layer 118-1 of the strained silicon layer 408 (i.e., portion of the Si layer 408 underneath the cut section 412 in Fig. 4C) remains attached to the insulator layer 112. Because the silicon layer 408 was strained, the silicon layer 118-1 is also strained, e.g., is under biaxial tensile strain. This completes formation of the SSOI structure 300 of Figs. 4D and 3A.

Referring again to the method 200 of Fig. 2A, after completion of the formation of the SSOI structure at 204, the method 200 proceeds from 204 to 208. At 208, alternating layers of sacrificial material (e.g., SiGe) and channel material (e.g., Si) are formed on the SSOI structure. For example, Fig. 3B illustrates formation of the alternating layers of sacrificial material 304 and channel material 318 on the SSOI structure. For example, the bottom-most layer and top-most layer of the alternating layers comprise corresponding layers of sacrificial material 304, as illustrated in Fig. 3B. Thus, sacrificial material 304 is formed directly on the silicon layer 118-1, followed by the channel material 318, followed by additional pairs of layers of sacrificial material 304 and channel material 318, and finally followed by a top-most layer of sacrificial material 304. In one example embodiment, the sacrificial material 304 is silicon germanium (SiGe), and the channel material 318 is silicon, which may be doped with a suitable dopant and concentration. Because the channel material 318 comprises silicon, the layers of channel material 318 is also referred to herein as silicon layers 318.

In an example, the substrate 110 may have a crystalline orientation described by a Miller index of (100), and the channel material 318 may have a crystalline orientation described by a Miller index of (100) or (110). In one example, the substrate 110 has a crystalline orientation described by a Miller index of (100), and the channel material 318 has a crystalline orientation described by a Miller index of (110), which results in formation of relatively stronger PMOS and NMOS devices.

Each layer of sacrificial material 304 or channel material 318 can be formed using any suitable processing, such as one or more deposition or epitaxial growth processes, as will be apparent in light of this disclosure. In one embodiment, alternating layers of sacrificial material and channel material can be formed using layer-by-layer epitaxial growth, where the sacrificial material can subsequently be removed to release nanoribbons of the channel material. In some embodiments, a given layer of channel material 318 may include a vertical channel height (dimension in the Z-axis direction) in the range of 5nm to 50 nm (or in a subrange of 5-45, 5-40, 5-35. 5-30. 5-25, 5-20, 5-15, 5-10, 10-40, 10-30, 10-20, 15-40, 15-30, 15-20, 20-40, 20-30 and 30-40 nm) and/or a maximum vertical thickness of at most 50, 40, 30, 25, 20, 15, or 10 nm, for example. Other suitable materials and channel height requirements or thresholds will be apparent in light of this disclosure.

In some embodiments, the channel materials 318 may be doped differently on different areas of the substrate, such as for CMOS applications, for example. For instance, a first area of a layer of channel material 318 may be doped appropriately for a p-channel transistor device, and a second area of the layer of channel material 318 may be doped appropriately for a n-channel transistor device. Thus, the doping profile of a section of the channel material 318 may be based on whether the section of the channel material 318 is to be eventually used to form a nanoribbon for a PMOS device or for an NMOS device. Note that the different areas of the channel materials may be doped differently using any suitable techniques, such as masking, doping, and removing the masking, as desired, to form any number of compositionally different doped channel materials. Numerous different channel material doping configurations and variations will be apparent in light of this disclosure.

As discussed herein previously with respect to Figs. 2B and 4A-4D, the SSOI structure 300 of Fig. 3A is formed such that the silicon layer 118-1 is a strained silicon layer that is under tensile strain. Referring now to Fig. 3B, when the bottom-most sacrificial layer 304 comprising SiGe is formed, this layer is lattice matched to the strained silicon layer 118-1, and hence, the bottom-most SiGe sacrificial layer 304 is relaxed.

Subsequently, when the bottom-most layer channel material 318 is formed on the bottom-most SiGe sacrificial layer 304, the bottom-most layer of channel material 318 is lattice matched to the relaxed SiGe of the bottom-most SiGe sacrificial layer 304. This causes the bottom-most Si layer of channel material 318 to be under tensile strain. Accordingly, the SiGe sacrificial layer 304 above the bottom-most Si layer of channel material 318 is relaxed, which in turn causes the layer of channel material 318 above it to be under tensile strain. Thus, in this manner, the tensile strain of the silicon layer 118-1 propagates vertically to all the Si layers of channel material 318 of Fig. 3B. Put differently, due to the lattice matching of the alternating layers of SiGe sacrificial material 304 and Si channel material 318 with the strained silicon layer 118-1, the layers of SiGe sacrificial material 304 are relaxed and the layers of channel material 318 are under tensile strain.

Referring again to Fig. 2A, the method 200 then proceeds from 208 to 212, where the alternating layers of sacrificial material and channel material and the top strained silicon layer of the SSOI structure are etched to define one or more fins. For example, Fig. 3C illustrates etching of the alternating layers of sacrificial material 304 and channel material 318 and the top strained silicon layer 118-1 of the SSOI structure, to define fins 306a, 306b, 306c. For example, the strained silicon layer 118-1 is etched to define strained silicon layers 118a1, 118b1, and 118c1 of the fins 306a, 306b, and 306c, respectively. Similarly, each layer of channel material 318 is etched to define corresponding layer of channel material 118a2, 118b2, and 118c2 of the fins 306a, 306b, and 306c, respectively. The etched portions of individual layers of the sacrificial material 304 are labelled using the same label "304" for each of fins 306a, 306b, and 306c.

Note that the silicon layer 118-1 and the layers of silicon channel material 318 were under tensile strain, e.g., as discussed with respect to operation 208 of Fig. 2A and Fig. 3B. Accordingly, the silicon layers 118a1, 118a2, 118b1, 118b2, 118c1, and 118c2 of the various fins in Fig. 3C are also under tensile strain.

In one embodiment, etching the various layers to define the fins 306a, 306b, 306c can be performed using any suitable techniques for etching and defining fins. For example, regions to be processed into the fins 306a, 306b, 306c are masked, followed by etching the surrounding regions to define the fins. For instance, an anisotropic etch proceeds substantially vertically through the upper fin portion to define isolation trenches between adjacent fins. In an example, the insulator layer 112 acts as an etch stop layer, and the insulator layer 112 (and the underneath substrate 110) is not etched during the fin formation process.

In some embodiments, each fin may include a vertical fin height (dimension in the Z-axis direction) in the range of 20-500 nm (or in a subrange of 20-50, 20-100, 20-200, 20-300, 20-400, 50-100, 50-200, 50-300, 50-400, 50-500, 100-250, 100-400, 100-500, 200-400, or 200-500 nm) and/or a maximum vertical fin height of at most 500, 450, 400, 350, 300, 250, 200, 150, 100, or 50 nm, for example. In some embodiments, each fin may include a horizontal fin width (dimension in the x-axis direction) in the range of 2-50 nm (or in a subrange of 2-5, 2-10, 5-10, 5-20, 5-30, 5-50, 10-20, 10-30, 10-50, 20-30, 20-50, or 30-50 nm) and/or a maximum horizontal fin width of at most 50, 30, 20, 10, or 5 nm, for example. In some embodiments, the ratio of fin height to fin width may be greater than 1, such as greater than 1.5, 2, 2.5, 3, 3.5, 4, 4.5, 5, 6, 7, 8, 9, 10, 15, 20, or greater than any other suitable threshold ratio, as will be apparent in light of this disclosure. Other suitable materials and thickness values/ranges/thresholds will be apparent in light of this disclosure.

Referring again to Fig. 2A, the method 200 then proceeds from 212 to 216, where a dummy gate structure is formed on the channel region of the fins, and subsequently source region and drain region are formed. Fig. 3D illustrates the dummy gate structure and the source region and drain region. It may be noted that the cross-section views of Figs. 3A-3C are along the AA' line of Fig. 1A (e.g., similar to Fig. 1B), where cross-section of nanoribbons of all three devices 102a, 102b, 102c are visible. In contrast, Fig. 3D (and subsequent Figs. 3E-3G) illustrates a cross-section view along line BB' of Fig. 1A, where only the device 102a is visible. Thus, in the cross-section views of Fig. 3D-3G, components and nanoribbons of only the device 102a are illustrated, and at least in part similar processes of Figs. 3D-3G can be replicated for the devices 102b and 102c as well.

Thus, Fig. 3D illustrates the device 102a, e.g., the dummy gate electrode 332 of the device 102a. In an example, the dummy gate electrode 332 comprises poly-Si. Gate spacers 134 are formed along opposite sides of the dummy gate electrode 332. For example, the gate spacers 134 comprise silicon nitride (Si₃N₄) or other suitable material, as will be appreciated.

The source region 106a and the drain region 108a of the device 102a are also illustrated in Fig. 3D. The source region 106a and the drain region 108a can be formed using any suitable techniques, in accordance with an embodiment of the present disclosure. For example, processing the source and drain regions can be performed by etching at least a portion of the exposed source and drain portion of the fins to remove the layer stack, and forming replacement source and drain material using any suitable techniques, such as chemical vapor deposition (CVD), physical vapor deposition (PVD), atomic layer deposition (ALD), vapor-phase epitaxy (VPE), molecular beam epitaxy (MBE), or liquid-phase epitaxy (LPE), for example. In some embodiments, the exposed source/drain regions of the fins need not be completely removed; instead, the material in the layer stack at the source/drain regions is converted to final source/drain regions by doping, implantation, and/or cladding with a source/drain material or other suitable processing, for example.

In some embodiments, the source and drain regions may be formed one polarity at a time, such as performing processing for one of n-type and p-type regions, and then performing processing for the other of the n-type and p-type regions. For example, if the devices 102a and 102b are of opposite type (one PMOS and another NMOS), then the source and drain regions 106a, 108a of the device 102a may be formed separately (e.g., in a separate process) from formation of the source and drain regions 106b, 108b of the device 102b. In some embodiments, the source and drain regions may include any suitable doping scheme, such as including suitable n-type and/or p-type dopant (e.g., in a concentration in the range of 1E16 to 1E22 atoms per cubic cm). However, in some embodiments, at least one source or drain region may be undoped/intrinsic or relatively minimally doped, such as including a dopant concentration of less than 1E16 atoms per cubic cm, for example.

Referring again to Fig. 2A, the method 200 then proceeds from 216 to 220, where the nanoribbons are released in the channel region, as also illustrated in Fig. 3E. Note that the bottom-most nanoribbon 118a1 is not fully released (e.g., partially released), as it is in direct contact with the insulator layer 112. Releasing the nanoribbons involve removing the dummy gate oxide and the dummy gate electrode 332 between the gate spacers 134, to expose the channel region of the fin. For example, a polycrystalline silicon dummy gate electrode can be removed using a wet etch process (e.g., nitric acid/hydrofluoric acid), an anisotropic dry etch, or other suitable etch process, as will be appreciated. At this stage of processing, the layer stack of alternating layers of channel material 118a and sacrificial material 304 is exposed in the channel region. The channel region extends between and contacts the source and drain regions, where tip regions of the layer stack in the are protected by the gate spacers. The sacrificial material 304 in the layer stack can then be removed by etch processing, in accordance with some embodiments.

Etching the sacrificial material 304 may be performed using any suitable wet or dry etching process such that the etch process selectively removes the sacrificial material and leaves intact the channel material of the nanoribbons 118a1, 118a2 of the device 102a, as illustrated in Fig. 3E. In one embodiment, the sacrificial material is silicon germanium (SiGe) and the channel material is electronic grade silicon (Si). For example, a gas-phase etch using an oxidizer and hydrofluoric acid (HF) has shown to selectively etch SiGe in SiGe/Si layer stacks. In another embodiment, a gas-phase chlorine trifluoride (ClF3) etch is used to remove the sacrificial SiGe material. The etch chemistry can be selected based on the germanium concentration, nanoribbon dimensions, and other factors, as will be appreciated. After removing the SiGe sacrificial material 304, the resulting channel region includes silicon nanoribbons 118a1, 118a2 (for the device 102a) extending between the source and drain regions 106a, 108a of the fin, where tip regions of the nanoribbons contact the source and drain regions and remain at least partially protected by the gate spacers 134. The nanoribbons of the other devices 102b, 102c are also similarly released, with the bottom-most nanoribbons 118b1 and 118c1 only partially released.

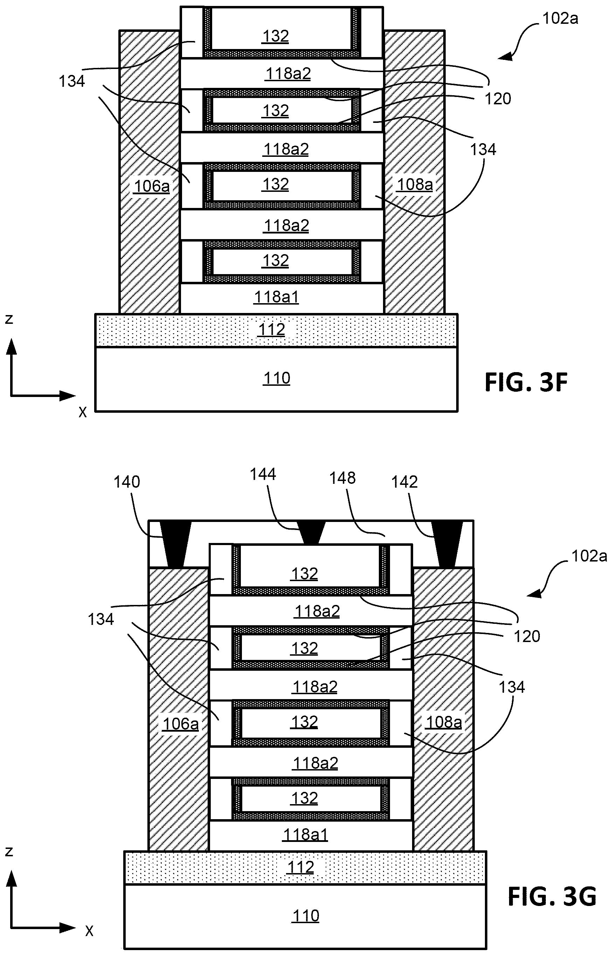

Referring again to Fig. 2A, the method 200 then proceeds from 220 to 224, where the final gate stack is formed. For example, Fig. 3F illustrates the device 102a, with the gate stack formed, where the gate stack comprises gate dielectric 120 wrapped around middle regions of individual nanoribbons 118a1, 118a2, and the gate electrode 132 around the gate dielectric 120. In an example, due to conformal deposition of the gate dielectric 120, the gate dielectric 120 may also be present on inner walls of the gate spacers 134, as seen in Fig. 3F.

In this example embodiment, the gate stack is formed using a gate-last fabrication flow, which may be considered a replacement gate or replacement metal gate (RMG) process. In embodiments utilizing a nanoribbon channel structure, the gate stack may substantially (or completely) surround each nanoribbon middle region portion, such as wrapping around at least 80, 85, 90, 95% or more of each nanoribbon. Processing the final gate stack includes depositing gate dielectric 120 on the exposed nanoribbon middle region in the channel region, followed by formation of a gate electrode 132 in contact with the gate dielectric 120. Tip regions of the nanoribbons 118a1, 118a2 are wrapped at least in part by the gate spacers 134.

Any suitable technique can be used for forming the replacement gate stack, including spin-coating or CVD deposition, for example. The gate dielectric may include, for example, any suitable oxide (such as silicon dioxide), high-k dielectric material, and/or any other suitable material as will be apparent in light of this disclosure. Examples of high-k dielectric materials include, for instance, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate, to provide some examples. In some embodiments, the gate dielectric can be annealed to improve its quality when high-k dielectric material is used. The gate electrode may include a wide range of materials, such as polysilicon or various suitable metals or metal alloys, such as aluminum (Al), tungsten (W), titanium (Ti), tantalum (Ta), copper (Cu), titanium nitride (TiN), or tantalum nitride (TaN), for example.

In some embodiments, gate dielectric and/or gate electrode may include a multilayer structure of two or more material layers, for example. For instance, in some embodiments, a multilayer gate dielectric may be employed to provide a more gradual electric transition from the channel region to the gate electrode, for example. In some embodiments, the gate dielectric and/or gate electrode may include grading (e.g., increasing and/or decreasing) the content or concentration of one or more materials in at least a portion of the feature(s). In some embodiments, one or more additional layers may also be present in the final gate stack, such as one or more relatively high or low work function layers and/or other suitable layers. Note that the gate dielectric may also be used to form replacement gate spacers on one or both sides of the nanoribbon body, such that the gate dielectric is between the gate electrode and one or both gate spacers, for example. Numerous different gate stack configurations will be apparent in light of this disclosure.

In one embodiment, one or more work function metals (such as work function metals 124) may be included around the nanoribbons 118, as illustrated in Fig. 1B, although the work function metals 124 are not illustrated in Fig. 3F for purposes of illustrative clarity. In some embodiments, a p-channel device may include a work function metal having titanium, and an n-channel device may include a work function metal having tungsten. In some other embodiments, the work function metal may be absent around one or more nanoribbons.

As discussed herein earlier and as seen in the cross-sectional view of Fig. 3F (and also in Figs. 1Ba and 1C), the bottom-most nanoribbon of individual devices 102a, 102b, 102c is formed directly on the insulator layer 112. Accordingly, the dielectric layer 120 and the work function metal layer 124 are on top and side surfaces, but not on the bottom surface, of the bottom-most nanoribbon 181a1, 181b1, 181c1 of individual devices 102a, 102b, 102c. The bottom surface of the bottom-most nanoribbon of individual devices 102a, 102b, 102c is in direct contact with the insulator layer 112. Thus, the bottom-most nanoribbon of individual devices 102a, 102b, 102c are partially, but not fully, wrapped around by the dielectric layer 120 and the work function metal layer 124. In contrast, the upper nanoribbons (i.e., nanoribbons 118a2, 118b2, 118c2) of each device 102 are fully wrapped around by the dielectric layer 120 and the work function metal layer 124, as illustrated in Fig. 1B. For similar reasons, the gate spacers 134 fully wrap the upper nanoribbons, but only partially wrap the bottom-most nanoribbon of individual devices 102.

The method 200 of Fig. 2A then proceeds from 224 to 228, where source/drain contacts are formed. Fig. 3G illustrates the device 102a, with source contacts 140 and drain contacts 142 formed. Note that Fig. 1A does not illustrate the source/drain contacts for purposes of illustrative clarity. Also, in Fig. 3G, an appropriate ILD 148 is deposited over the device 102a, and the source and drain contacts 140, 142 are formed through the ILD 148. Also illustrated is the gate contact 144 through the ILD 148.

In some embodiments, the source and drain contacts can be formed using any suitable techniques, such as forming contact trenches in the ILD layer 148 over the respective source/drain regions, and then depositing metal or metal alloy (or other suitable electrically conductive material) in the trenches. In some embodiments, forming the source/drain contacts may include silicidation, germanidation, III-V-idation, and/or annealing processes, for example. In some embodiments, the source and drain contacts may include aluminum or tungsten, although any suitable conductive metal or alloy can be used, such as silver, nickel-platinum, or nickel-aluminum, for example. In some embodiments, one or more of the source and drain contacts may include a resistance reducing metal and a contact plug metal, or just a contact plug, for instance. Example contact resistance reducing metals include, for instance, nickel, aluminum, titanium, gold, gold-germanium, nickel-platinum, nickel aluminum, and/or other such resistance reducing metals or alloys. Example contact plug metals include, for instance, aluminum, copper, nickel, platinum, titanium, or tungsten, or alloys thereof, although any suitably conductive contact metal or alloy may be used. In some embodiments, additional layers may be present in the source and drain contact regions, such as adhesion layers (e.g., titanium nitride) and/or liner or barrier layers (e.g., tantalum nitride), if so desired. In some embodiments, a contact resistance reducing layer may be present between a given source or drain region and its corresponding source or drain contact, such as a relatively highly doped (e.g., with dopant concentrations greater than 1E18, 1E19, 1E20, 1E21, or 1E22 atoms per cubic cm) intervening semiconductor material layer, for example. In some such embodiments, the contact resistance reducing layer may include semiconductor material and/or impurity dopants based on the included material and/or dopant concentration of the corresponding source or drain region, for example.

The method 200 of Fig. 2A then proceeds from 228 to 232, where a general integrated circuit (IC) is completed, as desired, in accordance with some embodiments. Such additional processing to complete an IC may include back-end or back-end-of-line (BEOL) processing to form one or more metallization layers and/or to interconnect the transistor devices formed, for example. Any other suitable processing may be performed, as will be apparent in light of this disclosure.

Note that the processes in method 200 are shown in a particular order for ease of description. However, one or more of the processes may be performed in a different order or may not be performed at all (and thus be optional), in accordance with some embodiments. Numerous variations on method 200 and the techniques described herein will be apparent in light of this disclosure.

### Example System

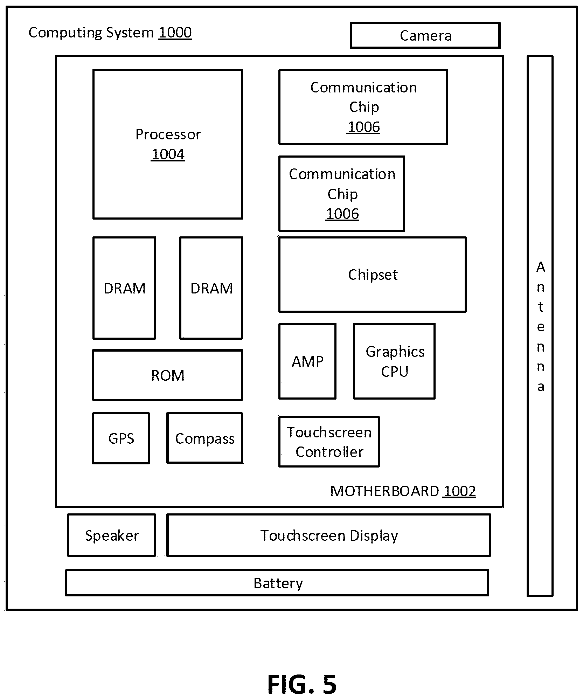

Fig. 5 illustrates a computing system 1000 implemented with integrated circuit structures and/or transistor devices formed using the techniques disclosed herein, in accordance with some embodiments of the present disclosure. As can be seen, the computing system 1000 houses a motherboard 1002. The motherboard 1002 may include a number of components, including, but not limited to, a processor 1004 and at least one communication chip 1006, each of which can be physically and electrically coupled to the motherboard 1002, or otherwise integrated therein. As will be appreciated, the motherboard 1002 may be, for example, any printed circuit board, whether a main board, a daughterboard mounted on a main board, or the only board of system 1000, etc.

Depending on its applications, computing system 1000 may include one or more other components that may or may not be physically and electrically coupled to the motherboard 1002. These other components may include, but are not limited to, volatile memory (e.g., DRAM), nonvolatile memory (e.g., ROM), a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth). Any of the components included in computing system 1000 may include one or more integrated circuit structures or devices formed using the disclosed techniques in accordance with an example embodiment. In some embodiments, multiple functions can be integrated into one or more chips (e.g., for instance, note that the communication chip 1006 can be part of or otherwise integrated into the processor 1004).

The communication chip 1006 enables wireless communications for the transfer of data to and from the computing system 1000. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 1006 may implement any of a number of wireless standards or protocols, including, but not limited to, Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing system 1000 may include a plurality of communication chips 1006. For instance, a first communication chip 1006 may be dedicated to shorter range wireless communications such as Wi-Fi and Bluetooth and a second communication chip 1006 may be dedicated to longer range wireless communications such as GPS, EDGE, GPRS, CDMA, WiMAX, LTE, Ev-DO, and others.

The processor 1004 of the computing system 1000 includes an integrated circuit die packaged within the processor 1004. In some embodiments, the integrated circuit die of the processor includes onboard circuitry that is implemented with one or more integrated circuit structures or devices formed using the disclosed techniques, as variously described herein. The term "processor" may refer to any device or portion of a device that processes, for instance, electronic data from registers and/or memory to transform that electronic data into other electronic data that may be stored in registers and/or memory.

The communication chip 1006 also may include an integrated circuit die packaged within the communication chip 1006. In accordance with some such example embodiments, the integrated circuit die of the communication chip includes one or more integrated circuit structures or devices formed using the disclosed techniques as variously described herein. As will be appreciated in light of this disclosure, note that multi-standard wireless capability may be integrated directly into the processor 1004 (e.g., where functionality of any chips 1006 is integrated into processor 1004, rather than having separate communication chips). Further note that processor 1004 may be a chip set having such wireless capability. In short, any number of processor 1004 and/or communication chips 1006 can be used. Likewise, any one chip or chip set can have multiple functions integrated therein.

In various implementations, the computing system 1000 may be a laptop, a netbook, a notebook, a smartphone, a tablet, a personal digital assistant (PDA), an ultra-mobile PC, a mobile phone, a desktop computer, a server, a printer, a scanner, a monitor, a set-top box, an entertainment control unit, a digital camera, a portable music player, a digital video recorder, or any other electronic device or system that processes data or employs one or more integrated circuit structures or devices formed using the disclosed techniques, as variously described herein. Note that reference to a computing system is intended to include computing devices, apparatuses, and other structures configured for computing or processing information.

### Further Example Embodiments

The following clauses pertain to further embodiments, from which numerous permutations and configurations will be apparent.

Example 1. A semiconductor structure comprising: a substrate; a layer over the substrate, the layer comprising insulator material; a source region and a drain region; a body comprising a semiconductor material over the layer and extending laterally between the source and drain regions, the semiconductor material of the body under biaxial tensile strain; and a gate structure at least in part wrapped around the body, the gate structure including (i) a gate electrode and (ii) a gate dielectric between the body and the gate electrode.

Example 2. The semiconductor structure of example 1, wherein: the body is in direct contact with the layer comprising oxygen, such that the gate structure partially, and not fully, wraps the body.

Example 3. The semiconductor structure of any one of examples 1-2, wherein: a bottom surface of the body is in direct contact with the layer comprising insulator material, and the gate structure is on a top surface and two side surfaces of the body.

Example 4. The semiconductor structure of any one of examples 1-3, wherein the body is a first body, and wherein the semiconductor structure further comprises: a second body comprising the semiconductor material over the first body and extending laterally between the source and drain regions, wherein the semiconductor material of the second body is under biaxial tensile strain, and wherein the gate structure fully wraps around the second body.

Example 5. The semiconductor structure of example 4, wherein the first body and the second body comprise silicon.

Example 6. The semiconductor structure of any one of examples 4-5, wherein the first body and the second body are included in a vertical stack including two or more nanowires, nanoribbons, or nanosheets.

Example 7. The semiconductor structure of any one of examples 4-6, further comprising: one or more additional bodies comprising the semiconductor material and extending laterally between the source and drain regions, the semiconductor material of the one or more additional bodies under biaxial tensile strain.

Example 8. The semiconductor structure of any one of examples 4-7, further comprising: a first spacer between the gate electrode and the source region, and a second spacer between the gate electrode and the drain region, wherein the first spacer and the second spacer fully wrap around tip regions of the second body and partially wrap around tip regions of the first body.

Example 9. The semiconductor structure of example 8, wherein the first and second spacers comprise silicon and nitrogen.

Example 10. The semiconductor structure of any one of examples 4-9, wherein: each of the first body and the second body comprises a corresponding middle region between corresponding tip regions; and the gate electrode and the gate dielectric at least in part wrap around the middle region of each of the first body and the second body.

Example 11. The semiconductor structure of any one of examples 1-10, wherein: the body, the layer comprising insulator material, and the substrate form a strained semiconductor on insulator (SSOI) structure that provides the stain.

Example 12. The semiconductor structure of any one of examples 1-11, wherein: the substrate comprises silicon with crystalline orientation described by a Miller index of (100); and the body comprises silicon with crystalline orientation described by a Miller index of (110).

Example 13. The semiconductor structure of any one of examples 1-12, wherein the substrate comprises silicon.

Example 14. The semiconductor structure of any one of examples 1-13, wherein the substrate essentially consists of silicon.

Example 15. The semiconductor structure of any one of examples 1-14, wherein the insulator material comprises oxygen and silicon.

Example 16. The semiconductor structure of any one of examples 1-15, wherein the semiconductor material of the body comprises silicon.

Example 17. The semiconductor structure of any one of examples 1-16, wherein the semiconductor material of the body is also under strain induced by the source and drain regions.

Example 18. The semiconductor structure of any one of examples 1-17, wherein the body is a nanowire, a nanoribbon, or a nanosheet.

Example 19. The semiconductor structure of any one of examples 1-18, wherein the body is part of a vertical stack including two or more bodies.

Example 20. The semiconductor structure of any one of examples 1-19, wherein the source region, drain region, gate structure, and body are part of a non-planar transistor.

Example 21. The semiconductor structure of any one of examples 1-20, wherein the source region, drain region, gate structure, and body are part of a gate-all-around transistor.

Example 22. The semiconductor structure of any one of examples 1-21, wherein the source region, drain region, gate structure, and body are part of a forksheet transistor.

Example 23. An integrated circuit structure comprising: a strained semiconductor on insulator (SSOI) structure; a first body and a second body both over the SSOI structure and comprising a semiconductor material that is under strain induced by the SSOI structure; a source region and a drain region, the first body and the second body between the source and drain regions; and a gate structure that fully wraps around the first body and the second body, the gate structure including (i) a gate electrode and (ii) gate dielectric separating the gate electrode from the first and second bodies.

Example 24. The integrated circuit structure of example 23, wherein the SSOI structure includes: a substrate; a first layer over the substrate, the first layer comprising oxygen; and a second layer on the first layer, the second layer comprising strained semiconductor material.

Example 25. The integrated circuit structure of example 24, wherein the gate structure only partially wraps around the second layer.

Example 26. The integrated circuit structure of any one of examples 24-25, wherein the strained semiconductor material is strained silicon.

Example 27. The integrated circuit structure of any one of examples 23-26, wherein the first body and the second body comprise silicon.

Example 28. The integrated circuit structure of any one of examples 23-27, wherein the first body and the second body are included in a vertical stack including two or more nanowires, nanoribbons, or nanosheets.

Example 29. The integrated circuit structure of any one of examples 23-28, further comprising: a first spacer between the gate electrode and the source region, and a second spacer between the gate electrode and the drain region, wherein the first spacer and the second spacer fully wrap around tip regions of the first and second bodies.

Example 30. The integrated circuit structure of example 29, wherein the first and second spacers comprise silicon and nitrogen.

Example 31. The semiconductor structure of any one of examples 23-30, wherein the semiconductor material of the first and second bodies is also under strain induced by the source and drain regions.

Example 32. An integrated circuit structure comprising: a first body and a second body comprising a semiconductor material that is under tensile strain; a source region and a drain region, the first body and the second body between the source and drain regions; and a gate structure that only partially wraps around the first body and fully wraps around the second body, the gate structure including (i) a gate electrode and (ii) gate dielectric separating the gate electrode from the first and second bodies.

Example 33. The integrated circuit structure of example 32, further comprising: a substrate; and a layer over the substrate, the layer comprising an insulator material, where the first body is in direct contact with the layer comprising the insulator material.

Example 34. The integrated circuit structure of example 33, wherein: a bottom surface of the first body is in direct contact with the layer comprising the insulator material, and the gate structure is on a top surface and two side surfaces of the first body.

Example 35. The integrated circuit structure of any one of examples 33-34, wherein: the first body, the layer comprising insulator material, and the substrate form a strained semiconductor on insulator (SSOI) structure.

Example 36. The integrated circuit structure of any one of examples 32-35, wherein the first body and the second body comprise silicon.

Example 37. The integrated circuit structure of any one of examples 3236, wherein the first body and the second body are included in a vertical stack including two or more nanowires, nanoribbons, or nanosheets.

Example 38. The integrated circuit structure of any one of examples 32-37, further comprising: a first spacer between the gate electrode and the source region, and a second spacer between the gate electrode and the drain region, wherein the first spacer and the second spacer fully wrap around tip regions of the second body, and only partially wrap around tip regions of the first body.

Example 39. The integrated circuit structure of example 38, wherein the first and second spacers comprise silicon and nitrogen.

Example 40. A method of forming a semiconductor device, comprising: forming a strained semiconductor on insulator (SSOI) structure comprising (i) a substrate, (ii) a first layer of insulating material over the substrate, and (iii) a second layer comprising strained semiconductor material over the first layer; forming alternating layers of channel material and sacrificial material, wherein the strain in the second layer is induced in the layers of channel material; etching the second layer and the alternating layers of channel material and sacrificial material to define a fin comprising corresponding sections of the second layer and the alternating layers of channel material and sacrificial material; and etching the section of the sacrificial material from the fin, to release at least the sections of the alternating layers of channel material, wherein the sections of the second layer and the alternating layers of channel material form a plurality of bodies comprising strained semiconductor material.

Example 41. The method of example 40, wherein the section of the second layer forms a bottom-most body of the plurality of bodies, and the sections of the alternating layers of channel material comprise one or more upper bodies of the plurality of bodies.

Example 42. The method of example 41, further comprising: forming a gate structure that only partially wraps around the bottom-most body and fully wraps around one or more of the upper bodies, the gate structure including (i) a gate electrode and (ii) gate dielectric separating the gate electrode from individual bodies of the plurality of bodies.

Example 43. The method of any one of examples 40-43, further comprising: epitaxially depositing a source region and a drain region, such that the bodies laterally extend between the source and drain regions, wherein the semiconductor material of the bodies is also under strain induced by the source and drain regions.

The foregoing description of example embodiments has been presented for the purposes of illustration and description. It is not intended to be exhaustive or to limit the present disclosure to the precise forms disclosed. Many modifications and variations are possible in light of this disclosure. It is intended that the scope of the present disclosure be limited not by this detailed description, but rather by the claims appended hereto. Future filed applications claiming priority to this application may claim the disclosed subject matter in a different manner, and may generally include any set of one or more limitations as variously disclosed or otherwise demonstrated herein.

## Claims

1. A semiconductor structure comprising:
a substrate;
a layer over the substrate, the layer comprising insulator material;
a source region and a drain region;
a body comprising a semiconductor material over the layer and extending laterally between the source and drain regions, the semiconductor material of the body under biaxial tensile strain; and
a gate structure at least in part wrapped around the body, the gate structure including (i) a gate electrode and (ii) a gate dielectric between the body and the gate electrode.

2. The semiconductor structure of claim 1, wherein: the body is in direct contact with the layer comprising oxygen, such that the gate structure partially, and not fully, wraps the body.

3. The semiconductor structure of claim 1 or 2, wherein:
a bottom surface of the body is in direct contact with the layer comprising insulator material, and the gate structure is on a top surface and two side surfaces of the body.

4. The semiconductor structure of any one of claims 1 through 3, wherein the body is a first body, and wherein the semiconductor structure further comprises:
a second body comprising the semiconductor material over the first body and extending laterally between the source and drain regions,
wherein the semiconductor material of the second body is under biaxial tensile strain, and
wherein the gate structure fully wraps around the second body.

5. The semiconductor structure of claim 4, wherein the first body and the second body comprise silicon.

6. The semiconductor structure of claim 4 or 5, wherein the first body and the second body are included in a vertical stack including two or more nanowires, nanoribbons, or nanosheets.

7. The semiconductor structure of any one of claims 4 through 6, further comprising:
one or more additional bodies comprising the semiconductor material and extending laterally between the source and drain regions, the semiconductor material of the one or more additional bodies under biaxial tensile strain.

8. The semiconductor structure of any one of claims 4 through 7, further comprising:
a first spacer between the gate electrode and the source region, and a second spacer between the gate electrode and the drain region,
wherein the first spacer and the second spacer fully wrap around tip regions of the second body and partially wrap around tip regions of the first body.

9. The semiconductor structure of claim 8, wherein the first and second spacers comprise silicon and nitrogen.

10. The semiconductor structure of any one of claims 4 through 9, wherein:
each of the first body and the second body comprises a corresponding middle region between corresponding tip regions; and
the gate electrode and the gate dielectric at least in part wrap around the middle region of each of the first body and the second body.

11. The semiconductor structure of any one of claims 1 through 10, wherein:
the substrate comprises silicon with crystalline orientation described by a Miller index of (100); and
the body comprises silicon with crystalline orientation described by a Miller index of (110).

12. The semiconductor structure of any one of claims 1 through 11, wherein the insulator material comprises oxygen and silicon.

13. The semiconductor structure of any one of claims 1 through 12, wherein the semiconductor material of the body is also under strain induced by the source and drain regions.

14. The semiconductor structure of any one of claims 1 through 13, wherein the source region, drain region, gate structure, and body are part of a gate-all-around transistor.

15. The semiconductor structure of any one of claims 1 through 13, wherein the source region, drain region, gate structure, and body are part of a forksheet transistor.
